# EUROPEAN PATENT APPLICATION

(11) **EP 0 896 419 A2**
(43) Date of publication of application: **10.02.1999**
(21) Application number: 98401768.1
(22) Date of filing: 13.07.1998
(51) Int. Cl.: H02M 3/28

(54) **Power converter incorporated in a magnetic circuit**

(30) Priority: 04.08.1997 ES 9701736
(71) Applicant: ALCATEL ALSTHOM COMPAGNIE GENERALE D'ELECTRICITE, 75008 Paris (FR)
(72) Inventor: Ollero Velasco, Salvador, 28007 Madrid (ES); de la Cruz Moreno, Enrique, 28002 Madrid (ES); Rascon Martinez, Miguel, 28002 Madrid (ES)
(74) Representative: Feray, Valérie

(57) **Abstract**

The power converter comprises magnetic means including a core formed by two core sections (21, 22) made from a magnetic material, and at least one of the windings on the aforementioned magnetic means is printed on a printed circuit board (23).

On the same printed circuit board (23), the rest of the components that constitute the converter are assembled in such a way that the core so formed completely encloses the printed circuit board (23). The printed circuit board (23) is situated inside the core window.

## Description

### OBJECT OF THE INVENTION

This invention refers to a power converter which comprises magnetic means formed by a core and several windings, and in which one of the windings is incorporated on a printed circuit board, for example.

The power converter is particularly, but not exclusively, applicable to a telecommunications system for the provision of electrical power to the electronic circuits that constitute the telecommunications system.

### STATE OF THE ART

Electronic integrated circuits, for example microprocessors, have evolved over recent years and, in general, now require the power converters that feed them to provide lower voltages and higher currents, for example. Consequently, the design parameters for the power converters have also changed and, as a result, the same has occurred with some of the components which form them, such as the magnetic means, the transformers and the inductances.

A power converter, when supplying a lower voltage, must be situated as close as possible to its load in order to avoid the losses that occur in distributing the current; consequently it should be assembled on the same printed circuit board as the load being fed.

The power converter generates electromagnetic interferences during normal operation and these interferences affect the normal operation of the electrical load. Consequently, said converter has to be designed to avoid the generation of said electromagnetic interferences; this means there is an extra cost in the converter resulting from the measures to be taken to reduce the interferences.

The converter has to be small in size in order to take up the smallest surface on the board; consequently, the dimensions of the components with the greatest impact on the size of the converter, the magnetic means for example, have to be reduced as much as possible during the design stage. These means present also an additional problem which is their height, since they are the highest components in the power converter.

The magnetic means present other problems, such as their high impact on the overall cost of the power converter since the materials employed in their construction and its manufacture are expensive, given that it is not always possible to automate their production and assembly.

### CHARACTERIZATION OF THE INVENTION

The main object of this invention is to provide a power converter that can offer a high level of power density and of integration, reduced electromagnetic radiation, and is small in size.

It is another object of the invention that the converter incorporates some means that make maximum use of the window defined by its core, these being manufactured and assembled automatically and therefore being easy to reproduce.

It is another object of the invention that magnetic flux paths are well defined on the magnetic core whereby the radiated field produced by the current flowing along the tracks of the printed circuit board is reduced and its effect outside the converter is avoided.

By incorporating the windings on the printed circuit board, spread flux, as well as parasites in the associated magnetic means, are limited; also electromagnetic interferences are drastically reduced both in the converter itself, as well as in the load or loads which it feeds.

It is another object of the invention to reduce the losses in the core of the magnetic circuit. The core offers a greater area for the magnetic flux to pass and, as a result, the losses in it and, consequently, in the power converter are diminished. Therefore the power converter of the invention presents high efficiency and low cost.

The power converter incorporated in a magnetic circuit comprises at least a number of magnetic means which include a core formed by two core sections, made from a magnetic material, and at least one of the windings of the magnetic means is incorporated on a printed circuit board.

On the same printed circuit board the rest of the components that constitute the converter are assembled, such that the core so formed completely encloses the printed circuit board. The printed circuit board is situated in the core window.

This manner of constructing the power converter provides shielding both for the windings of the magnetic means and for the rest of the components of the converter that are assembled in the core window, thereby avoiding electromagnetic interferences.

This power converter provides a high power density, as well as a low height, permitting it to be used as a module on printed circuit boards, able to be located very close to the electrical load it feeds.

### BRIEF DESCRIPTION OF THE FIGURES

A fuller explanation of the invention is given in the following description, based on the figures attached, in which:
- figure 1 shows a block diagram of the power converter according to the invention;
- figure 2 shows an exploded perspective view of the power converter incorporated in a magnetic circuit according to the invention, and
- figure 3 shows a sectional view on the plane d-d' indicated in figure 2 of the power converter incorporated in a magnetic circuit according to the invention.

### DESCRIPTION OF THE INVENTION

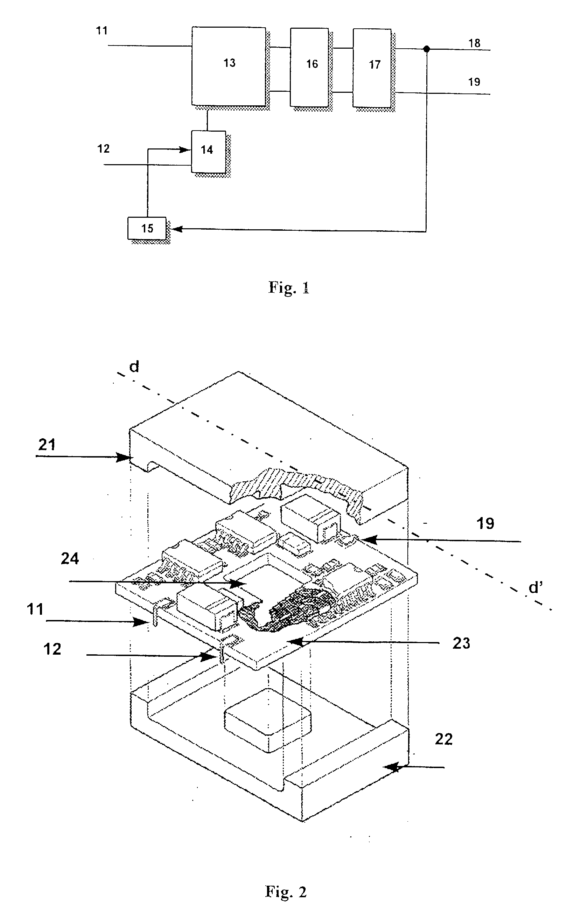

Figure 1 shows a block digram of a power converter and how it is connected. Thus, the power converter is connected to a voltage source through terminals 11, 12. One of the terminals, 11, is connected to one end of a primary winding of a transformer 13, the other end of the same primary winding being connected to a switching element 14 which, in turn, is connected to the other terminal 12. A control means 15 governs the ON time of said switching element 14. All of the foregoing description corresponds to the primary side of the transformer 13.

The secondary side of the transformer 13 is connected to a rectifier module 16 and this to an output filter 17 which is connected via output terminals 18, 19 to an electrical load, not shown in figure 1.

No detailed description will be given of the implementation of the power converter since this is not an object of this patent because the converter, depending on the output power and voltage, may be implemented in different topologies, for example as a forward converter or a flyback converter. The topology selection criterion is a function of the specific application.

However it has to be pointed out that the topology and the operating mode of the converter determine the number of magnetic means, for example a forward converter includes at least the transformer 13 and an inductance included in the output filter 17, not shown in figure 1.

According to the aforesaid, the power converter is implemented with a forward topology, this topology being taken by way of example to better describe the invention, without thereby restricting said power converter to this topology.

Figure 2 shows an exploded perspective view of the power converter situated inside the core of the magnetic means. To better explain the invention it will be considered that this core is common to the transformer 13 and to the inductance of the output filter 17, without thereby restricting the power converter to this implementation.

The core is formed by at least two core sections 21 and 22, it being possible that the two sections are of type "E", for example; or different, one being of type "E" and the other of type "I", for example; or two non-standardised sections, all of them being made from a magnetic material.

The core of the magnetic means is not only dimensioned from the point of view of the effective area for the flux level circulating, but it is also dimensioned to enclose both the windings incorporated on a printed circuit board 23, and the components of the power converter assembled on the same printed circuit board 23; there being lower losses in the core since the flux density is less.

The power converter, being shielded by the core, has its electromagnetic radiations reduced and, therefore, the level of interference in the operation of its load and in other electrical equipments is diminished.

Another advantage obtained from this method of construction is that the power converter is protected against the harmful effects of electromagnetic radiations produced by other equipments.

The windings of the magnetic means, by being incorporated in the printed circuit board 23, have the advantage that these magnetic means, transformer 13 and inductance, can be manufactured and assembled automatically and, in addition, very similar properties are obtained through mass production.

The number of layers of the printed circuit board 23 depends on the number of windings and on the turns ratios.

For the foregoing, the power converter incorporated in a magnetic circuit offers a more effective distribution of the windings from the physical layout viewpoint, a better use of the core window and better electromagnetic shielding.

When the magnetic means comprise more than one winding, they are laid on the intermediate layers of the printed circuit board 23, while the components of the power converter, such as the switching element 14, the rectifier module 16, the control module 15 and the output filter 17, are assembled on one of the outside faces of said board 23, or they may also be assembled on the other outside face of said board 23 in order to achieve a greater degree of package in the power converter.

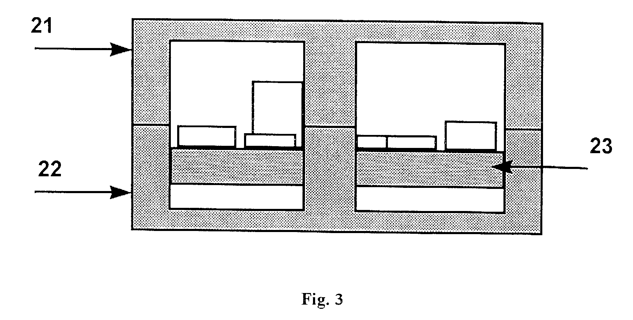

As it is shown in figure 3, the printed circuit board 23 is situated in the core window, the components being assembled on the board within the area of the window, the degree of package of the power converter being thereby increased and, as a result, its size reduced.

In the implementation shown in figures 2 and 3, two non-standard core sections 21, 22 have been employed. In this case, the printed circuit board 23 has a regularly shaped opening 24 to facilitate its being lodged inside the core window.

In the event that the power converter should include a very bulky element, for example a capacitor, due to the power requirements of the load, this element will be assembled on the outside of the printed circuit board 23 and will be situated outside the core, for example near one of the terminals 11, 12, 18, 19 of the converter.

Other elements of the converter can also be assembled outside the core window. A balance has to be found between the size, the electrical requirements of the converter and its cost, adopting in each case the most suitable design.

In a given case it may be necessary for the magnetic means to comprise several cores. In such a case, the cores will be arranged one after the other in such a way that the printed circuit board 23 is enclosed by all of them.

## Claims

1. **Power converter incorporated in a magnetic circuit** comprising magnetic means with at least one core formed by at least two core sections (21, 22) and a printed circuit board (23) on which at least one winding of said magnetic means is printed; **characterized in that** the core sections (21, 22) enclose said printed circuit board (23) on which the components that form said power converter are assembled.

2. **Power converter** according to claim 1, **characterized in that** the components of said power converter are assembled on the two outside faces of the printed circuit board (23).

3. **Power converter** according to claim 2, **characterized in that** some of the components assembled on said printed circuit board (23) are situated outside the core window of said magnetic means.

4. **Power converter** according to claim 3, **characterized in that** the printed circuit board (23) is a multilayer one.

5. **Power converter** according to claim 1, **characterized in that** said magnetic means comprise several cores which enclose said printed circuit board (23).
